# EUROPEAN PATENT APPLICATION

(11) **EP 2 061 089 A1**
(43) Date of publication of application: **20.05.2009**
(21) Application number: 06797700.9
(22) Date of filing: 08.09.2006
(51) Int. Cl.: H01L 31/042

(54) **SOLAR BATTERY PANEL AND METHOD FOR MANUFACTURING SOLAR BATTERY PANEL**

(71) Applicant: Mitsubishi Heavy Industries, Ltd., Tokyo 108-8215 (JP)
(72) Inventor: SASAKAWA, Eishiro, Nagasaki-shi, Nagasaki 850-8610 (JP); KOKAJI, Satoshi, Nagasaki-shi, Nagasaki 850-8610 (JP); OGAWA, Kazuhiko, Nagasaki-shi, Nagasaki 850-8610 (JP); HORIOKA, Tatsuji, Nagasaki-shi, Nagasaki 850-8610 (JP)
(74) Representative: Bongiovanni, Simone
(86) International application number: PCT/JP2006/317846
(87) International publication number: WO 2008/029476

(57) **Abstract**

A solar panel has a substrate (1) and a plurality of photovoltaic cells (5). The substrate (1) has a first side (1a), a second side (1b), a third side (1c) and a fourth side (1d). The plurality of photovoltaic cells (5) are provided on the substrate (1), arranged parallel to the first side (1a), and connected in series one after another. The plurality of photovoltaic cells (5) have a first trench (15a) located adjacent to the first side (1a) and parallel to the first side (1a) and a second trench (15b) located adjacent to the second side (1b) and parallel to the second side (1b), while do not have a trench located adjacent to the third side (1c) and parallel to the third side (1c) and a trench located adjacent to the fourth side (1d) and parallel to the fourth side (1d). The first trench (15a) and the second trench (15b) are formed from a surface of the plurality of photovoltaic cells (5) toward a surface of the substrate (1), and so extend to vicinities of the third side (1c) and the fourth side (1d) as not to reach an edge of the substrate (1).

## Description

### Technical Field

The present invention relates to a solar panel provided with a thin-film silicon-based solar cell such as an amorphous silicon-based solar cell, a microcrystalline silicon-based solar cell, a tandem-type solar cell in which an amorphous silicon-based solar cell and a microcrystalline silicon-based solar cell are laminated and the like, and a method of manufacturing the solar panel. In particular, the present invention relates to a solar panel and a method of manufacturing the solar panel which are capable of improving productivity and long-term reliability of a solar cell.

### Background Art

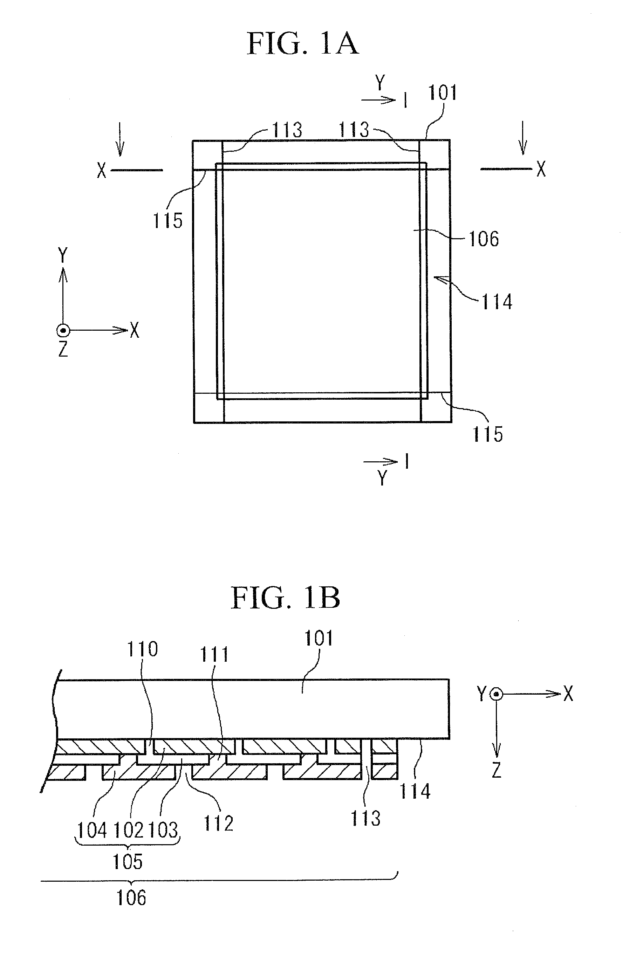

A thin-film silicon-based solar cell (hereinafter, referred to as a solar panel) that is formed by laminating a silicon-based thin film on a translucent substrate is known. FIG. 1A and FIG. 1B show a conventional solar panel. FIG. 1A is a top plan view, and FIG. 1B is a cross-sectional view along a line XX in FIG. 1A.

The solar panel has a substrate 101 and a solar cell module 106. The solar cell module 106 is provided on a surface of the substrate 101, surrounded by a peripheral region 114. The solar cell module 106 has a plurality of photovoltaic cells 105, and also has an X-direction insulating trench 115 and a Y-direction insulating trench 113 that are formed on entire circumference of the inside of the edge of the solar cell module 106. The X-direction insulating trench 115 extends in the X-direction. The Y-direction insulating trench 113 extends in the Y-direction. The photovoltaic cell 105 includes a transparent conductive layer 102, a photoelectric conversion layer 103 and a back electrode layer 104. The transparent conductive layer 102 is formed on the substrate 101, and is so divided by trenches 110 extending in the Y-direction as to correspond to the plurality of photovoltaic cells 105. The photoelectric conversion layer 103 is formed on the transparent conductive layer 102, and is so divided by trenches 111 extending in the Y-direction as to correspond to the plurality of photovoltaic cells 105. The back electrode layer 104 is formed on the photoelectric conversion layer 103, and is so divided by trenches 112 extending in the Y-direction as to correspond to the plurality of photovoltaic cells 105.

As described above, the conventional solar panel has isolation trenches for insulation (the X-direction insulating trench 115 and the Y-direction insulating trench 113) on the entire circumference of the inside of the edge of the solar cell module 106 (refer to, for example, Japanese Patent Publications JP-3243227, JP-3243229 and JP-3243232). Such the isolation trenches are important in electrically isolating short-circuit sections between the transparent conductive layer 102 and the back electrode layer 104 near the edge of the solar cell module 106 of the photovoltaic cells 105 to prevent occurrence of short-circuit in the photovoltaic cells 105. Moreover, the isolation trenches are effective in suppressing deterioration in performance of the solar cell module 106 caused by intrusion of external moisture through a sealed region around the edge section of the solar panel. However, since the isolation trenches (and also the trenches 110) reach the edge of the substrate, there is a possibility that the external moisture intrude into the photovoltaic cells 105 from the portion of the trenches at the edge of the substrate. In that case, the photovoltaic cells 105 deteriorate due to the moisture, which causes decrease in long-term reliability. Therefore, a technique that can further improve the long-term reliability is desired. Moreover, in the case where the isolation trenches are provided on the entire circumference of the inside of the edge of the solar cell module 106, the processing time is increased. A technique is desired that is capable of not only suppressing the decrease in the performance of the solar cell module 106 to improve the long-term reliability but also reducing the processing time required for the isolation trench processing around the edge of the solar cell module 106 to improve the productivity.

Furthermore, according to the conventional solar panel, a film of the photovoltaic cells which exists in the peripheral region 114 of the solar cell module is removed by grinding (refer to, for example, Japanese Laid-Open Patent Application JP-A-Heisei 8-83923 and Japanese Laid-Open Patent Application JP-P2003-142717). To remove the film in the peripheral region 114 is important in improving adhesiveness between a sheet used for sealing the solar cell module 106 (not shown, but connecting a back sheet via EVA (EVA: ethylene-vinyl acetate copolymer) will be described later) and an exposed surface of the peripheral region 114 and thus improving protection effect by the sheet with respect to the solar cell module 106. However, if the film of the peripheral region 114 is not removed sufficiently and hence the adhesive strength becomes insufficient, or if the film remains partially and hence a void remains in the adhesion site, or if a grinding groove along a direction intersecting circumference of the substrate is present at the exposed region of the substrate 101 when the film is removed, a line (of several tens of micrometers) which may possibly cause capillary phenomenon remains between the sheet and the substrate 101, and thus external moisture can intrude into the photovoltaic cells 105 therefrom. In that case, the photovoltaic cells 105 deteriorate due to the moisture, which causes decrease in the long-term reliability. Although such a situation that causes the deterioration in the performance has recently become clear by long-term outdoor exposure test, no measure against that is embodied. A technique is desired that is capable of polishing the peripheral region 114 suitably without deteriorating the long-term reliability.

It should be noted that the silicon-based is a general term for material including silicon such as silicon (Si), silicon carbide (SiC) and silicon germanium (SiGe). The microcrystalline silicon-based means the silicon-based other than amorphous silicon-based, i.e., non-crystalline silicon-based, and includes polycrystalline silicon-based and crystalline silicon-base containing amorous material. The thin-film silicon-based includes the amorphous silicon-based, the microcrystalline silicon-based, and the tandem-type in which the amorphous silicon-based and the microcrystalline silicon-based are laminated.

### Disclosure of Invention

An object of the present invention is to provide a solar panel and a method of manufacturing the solar panel which can suitably perform the trench processing for a solar cell module to further improve the long-term reliability.

Another object of the present invention is to provide a solar panel and a method of manufacturing the solar panel which can reduce the trench processing around an edge of a solar cell module to improve the productivity without deteriorating the performance of the solar cell module.

Still another object of the present invention is to provide a solar panel and a method of manufacturing the solar panel which can suitably perform the polishing of a film of a photovoltaic cell in a peripheral region of a solar cell module without deteriorating the long-term reliability.

In a first aspect of the present invention, a solar panel is provided. The solar panel has a substrate and a plurality of photovoltaic cells. The substrate is a translucent substrate having a first side, a second side facing the first side, a third side between the first side and the second side, and a fourth side facing the third side. The plurality of photovoltaic cells are provided on the substrate, arranged parallel to the first side, and connected in series one after another. Each of the plurality photovoltaic cells includes a transparent conductive layer, a photoelectric conversion layer and a back electrode layer which are formed on the substrate in this order. The plurality of photovoltaic cells have a first trench located adjacent to the first side and parallel to the first side and a second trench located adjacent to the second side and parallel to the second side, while do not have a trench located adjacent to the third side and parallel to the third side and a trench located adjacent to the fourth side and parallel to the fourth side. The first trench and the second trench are formed from the back electrode layer being a surface of the plurality of photovoltaic cells toward a surface of the substrate, and so extend to vicinities of the third side and the fourth side as not to reach an edge of the substrate.

Here, the photoelectric conversion layer may have a laminated-structure of a p-layer, an i-layer and a n-layer made of thin-film silicon, or may constitute a tandem-type solar cell in which a plurality of the laminated-structures are further laminated. The first trench and the second trench function as insulating trenches. The isolation trenches are important in electrically isolating short-circuit sections between the transparent conductive layer and the back electrode layer near an edge of the solar cell module of the photovoltaic cells to prevent occurrence of short-circuit in the photovoltaiccells. Moreover, the isolation trenches are effective in suppressing deterioration in performance of the solar cell module caused by intrusion of external moisture through a sealed region around the edge section of the solar panel.

Since the first trench and the second trench do not reach the edge of the substrate, it can be prevented that the external moisture intrudes from the edge of the substrate, capillary phenomenon occurs at the first trench and the second trench, and the moisture intrudes into the inside of the solar cell module. In addition, it is found that the trench parallel to the third side and the trench parallel to the fourth side can be omitted if there is a process of removing a film of photovoltaic cell existing in the peripheral region of the solar cell module by polishing. Since processes of forming the trench parallel to the third side and the trench parallel to the fourth side are eliminated, it is possible to reduce the processing time of the trench processing. That is, it is possible not only to suppress the deterioration in performance of the solar cell module and thus improve the long-term reliability but also to reduce the trench processing processes around the edge sections of the solar cell module.

In the above-mentioned solar panel, it is preferable that edges of the first trench and the second trench are away from the edge of the substrate at a distance not less than 5 mm and not more than 10 mm. With regard to the distance, it is desirable for suppressing the intrusion of the external moisture from the edge of the substrate that a good adhesion region for a sheet in the peripheral region is larger than 5 mm. Moreover, it is desirable to design the above-mentioned distance to be not more than 10 mm in order to secure an area of the solar cell module as large as possible while ensuring the peripheral region.

The plurality of photovoltaic cells preferably has a first film formed on the substrate. The first film has a third trench extending in a direction different from directions of the first side and the second side. The third trench is formed from a surface of the first film toward the surface of the substrate, and so extends to vicinities of the first side and the second side as not to reach the edge of the substrate. The third trench is necessary for forming on the substrate the plurality of strip-shaped photovoltaic cells that are connected in series. Since the third trench does not reach the edge of the substrate, the intrusion of the external moisture from the edge of the substrate can be prevented, as in the above-mentioned case of the first trench and the second trench that are the insulating trenches. In other words, it is possible to suitably perform the trench processing processes with respect to the solar cell module such that the long-term reliability is further improved.

It is preferable that an edge of the third trench is away from the edge of the substrate at a distance not less than 5 mm and not more than 10 mm. Such a distance is preferable to secure an area of the solar cell module as large as possible while ensuring the peripheral region, as in the above-mentioned case of the first trench and the second trench that are the insulating trenches.

In a second aspect of the present invention, a method of manufacturing a solar panel is provided. The manufacturing method has: (a) a process of forming a plurality of photovoltaic cells on a substrate having a first side, a second side facing the first side, a third side between the first side and the second side, and a fourth side facing the third side. Each of the plurality photovoltaic cells includes a transparent conductive layer, a photoelectric conversion layer and a back electrode layer which are formed on the substrate in this order. Moreover, the plurality of photovoltaic cells are arranged parallel to the first side and connected in series one after another. The manufacturing method according to the present invention further has: (b) a process of forming a first trench located adjacent to the first side and parallel to the first side and a second trench located adjacent to the second side and parallel to the second side. A trench located adjacent to the third side and parallel to the third side and a trench located adjacent to the fourth side and parallel to the fourth side are not formed. The above-mentioned first trench and the second trench are formed from the back electrode layer being a surface of the plurality of photovoltaic cells toward a surface of the substrate, and so extend to vicinities of the third side and the fourth side as not to reach an edge of the substrate.

It is preferable that the above-mentioned (b) process includes: (b1) a process of forming the first trench and the second trench such that edges of the first trench and the second trench are away from an edge of the substrate at a distance not less than 5 mm and not more than 10 mm.

It is preferable that the above-mentioned (a) process includes: (a1) a process of forming a transparent conductive layer on the substrate; and (a2) a process of forming in the transparent conductive layer a third trench extending in a direction different from directions of the first side and the second side. The third trench is formed from a surface of the transparent conductive layer toward a surface of the substrate, and so extends to vicinities of the first side and the second side as not to reach an edge of the substrate.

It is preferable that the above-mentioned (a2) process includes: (a21) a process of forming the third trench such that an edge of the third trench is away from the edge of the substrate at a distance not less than 5 mm and not more than 10 mm.

The method of manufacturing the solar panel according to the present invention can further has: (c) a process of removing a part of a film for the plurality of photovoltaic cells laminated on the substrate using a sheet material, to form an exposed surface as an adhesive surface of the sheet material. The above-mentioned (c) process preferably includes: (c1) a process of polishing the film for the plurality of photovoltaic cells in a peripheral section of the substrate through a polishing with a rotating grindstone; and (c2) a process of polishing the film for the plurality of photovoltaic cells in the peripheral section of the substrate through a blast grinding, after the (c1) process.

A part of the film of the photovoltaic cell in the peripheral region of the solar cell module is removed. The exposed part on the substrate becomes an adhesive surface with respect to a back sheet which seals the solar cell module via EVA (ethylene-vinyl acetate copolymer) and the like. It is desirable with regard to the adhesive surface that the substrate is exposed. If a conductive portion of the transparent conductive layer remains, the isolation characteristics may deteriorate. It is also found that, if a fine scar or a fine groove of several tens of micrometers generated in the exposed part on the substrate remains in a direction intersecting with circumference sides of the substrate at this time, the moisture may possibly intrude into the solar cell module when the external moisture intrudes from the sealed section at the edge of the solar panel.

By performing a rough grinding with using the rotating grindstone and removing the remaining film through the blast grinding, it is possible not only to prevent the formation of the scar and the groove and remove the film surely but also to suppress decrease in production efficiency. As a result, it is prevented that the external moisture intrudes into the solar cell module due to the scar and the groove causing the capillary phenomenon in the adhesion site with respect to the back sheet via the EVA and the like in the peripheral region of the solar cell module. In other words, it is possible to suitably perform the polishing of the peripheral region of the solar cell module without deteriorating the long-term reliability.

The method of manufacturing the solar panel according to the present invention may further has: (d) a process of polishing the peripheral section of the substrate with a grindstone such that a grinding groove generated by the grindstone does not cross the first side, the second side, the third side and the fourth side, in respective cases where the (c2) process is performed and where the (c2) process is not performed, after the (c1) process.

It is preferable that the grindstone with the same fineness or a finer one is used for the grinding. Since the finish grinding of the peripheral section is so performed as not to cross the respective sides of the substrate, it is possible to cut off a path through which the external moisture intrudes from the edge of the substrate along the scar and the groove which are from the edge of the solar panel toward the inside of the solar cell module, and to prevent the intrusion of the moisture. That is to say, it is prevented that the external moisture intrudes into the solar cell module due to the scar and the groove causing the capillary phenomenon in the adhesion site with respect to the back sheet via the EVA and the like in the peripheral region of the solar cell module. It is possible to suitably perform the polishing of the peripheral region of the solar cell module such that the long-term reliability is further improved.

According to the present invention, it is possible to prevent the deterioration in the performance of the solar cell module, to prevent the deterioration in the long-term reliability, to suitably perform the trench processing processes with respect to the solar cell module, to reduce the processing time for the trench processing processes, to suitably perform the polishing of the peripheral region of the solar cell module, and to improve the long-term reliability.

### Brief Description of Drawings

[FIG. 1A] FIG. 1A is a top plan view showing a conventional solar panel.
[FIG. 1B] FIG.1B is a cross-sectional view showing the conventional solar panel.
[FIG. 2] FIG. 2 is a top plan view showing a structure of a solar panel according to an embodiment of the present invention.
[FIG. 3] FIG. 3 is a cross-sectional view showing a structure of a solar cell module 6 according the embodiment of the present invention.
[FIG. 4] FIG. 4 is a schematic view magnifying the section-A shown in FIG. 2.
[FIG. 5] FIG. 5 is a view regarding a peripheral region of the solar panel in the embodiment of the present invention.
[FIG. 6A] FIG. 6A is a cross-sectional view showing a method of manufacturing a solar panel according to the embodiment of the present invention.
[FIG. 6B] FIG. 6B is a cross-sectional view showing a method of manufacturing the solar panel according to the embodiment of the present invention.
[FIG. 6C] FIG. 6C is a cross-sectional view showing a method of manufacturing the solar panel according to the embodiment of the present invention.
[FIG. 6D] FIG. 6D is a cross-sectional view showing a method of manufacturing the solar panel according to the embodiment of the present invention.
[FIG. 6E] FIG. 6E is a cross-sectional view showing a method of manufacturing the solar panel according to the embodiment of the present invention.
[FIG. 6F] FIG. 6F is a cross-sectional view showing a method of manufacturing the solar panel according to the embodiment of the present invention.
[FIG. 6G] FIG. 6G is a cross-sectional view showing a method of manufacturing the solar panel according to the embodiment of the present invention.
[FIG. 6H] FIG. 6H is a cross-sectional view showing a method of manufacturing the solar panel according to the embodiment of the present invention.
[FIG. 7A] FIG. 7A is a schematic diagram showing a method of manufacturing the solar panel according to the embodiment of the present invention.
[FIG. 7B] FIG. 7B is a schematic diagram showing a method of manufacturing the solar panel according to the embodiment of the present invention.
[FIG. 8A] FIG. 8A is a schematic diagram showing a method of manufacturing the solar panel according to the embodiment of the present invention.
[FIG. 8B] FIG. 8B is a schematic diagram showing a method of manufacturing the solar panel according to the embodiment of the present invention.
[FIG. 8C] FIG. 8C is a schematic diagram showing a method of manufacturing the solar panel according to the embodiment of the present invention.
[FIG. 8D] FIG. 8D is a schematic diagram showing a method of manufacturing the solar panel according to the embodiment of the present invention.
[FIG. 9] FIG. 9 is a table showing a comparison of performances between processing methods of insulating trenches of the solar panel according to the present invention.

### Best Mode for Carrying Out the Invention

A solar panel and a method of manufacturing the solar panel according to an embodiment of the present invention will be described below with reference to the attached drawings.

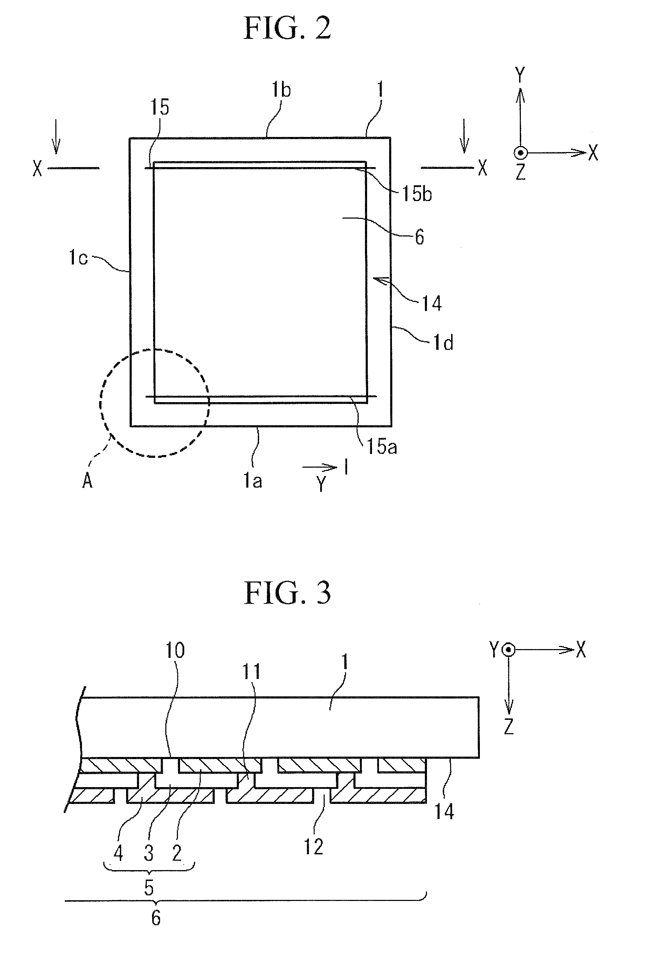

First, a structure of the solar panel according to the embodiment of the present invention will be described with reference to the attached drawings. FIG. 2 is a top plan view showing a structure of the solar panel according to the embodiment of the present invention. The solar panel has a substrate 1 and a solar cell module 6.

The substrate 1 has a first side 1a, a second side 1b facing the first side 1a, a third side 1c between the first side 1a and the second side 1b, and a fourth side 1d facing the third side 1c. The third side 1c and the fourth side 1d are sides connecting between the first side 1a and the second side 1b. The substrate 1 has translucency, and its material is preferably glass, for example.

The solar cell module 6 is provided on a surface of the substrate 1 and surrounded by a peripheral region 14 on whose surface no film exists. The solar cell module 6 has a plurality of photovoltaic cells 5 (to be described later), and also has an X-direction insulating trench 15a and an X-direction insulating trench 15b which are provided inside an edge of the solar cell module 6.

The X-direction insulating trench 15a is located adjacent to the first side 1a and parallel to the first side 1a. The X-direction insulating trench 15b is located adjacent to the second side 1b and parallel to the second side 1b. With regard to a depth direction, the X-direction insulating trench 15a and the X-direction insulating trench 15b are formed from a back electrode layer 4 being a surface of the plurality of photovoltaic cells 5 toward the surface of the substrate 1. The X-direction insulating trench 15a and the X-direction insulating trench 15b reach the surface of the substrate 1, while preferably do not extend into the substrate 1 so that the strength of the substrate 1 is secured. With regard to a length direction, on the other hand, the X-direction insulating trench 15a and the X-direction insulating trench 15b extend in the X-direction. With regard to each of the X-direction insulating trenches 15a and 15b, one end extends to a vicinity of the third side 1c and the other end extends to a vicinity of the fourth side 1d. The both sides do not reach the edge of the substrate 1. A width of each of the X-direction insulating trench 15a and 15b is, for example, 50 to 100 micrometers.

FIG. 3 is a cross-sectional view showing the structure of the solar cell module 6 of the solar panel according to the embodiment of the present invention, and shows a part of the cross-section along a line XX in FIG. 2. The plurality of photovoltaic cells 5 are provided on the substrate 1, arranged parallel to the first side 1a, and connected in series one after another. Each photovoltaic cell 5 includes a transparent conductive layer 2, a photoelectric conversion layer 3, and a back electrode layer 4.

The transparent conductive layer 2 is formed on the substrate 1. The transparent conductive layer 2 is so divided by trenches 10 extending in the Y-direction as to correspond to the plurality of strip-shaped solar cells 5. With regard to the depth direction, the trenches 10 are formed from a surface of the transparent conductive layer 2 toward the surface of the substrate 1. With regard to a length direction, the trenches 10 so extend to the vicinities of the first side 1a and the second side 1b as not to reach the edge of the substrate 1. A width of the trench 10 is, for example, 10 to 50 micrometers.

The photoelectric conversion layer 3 has a laminated-structure of a p-layer, an i-layer and a n-layer made of thin-film silicon, or may constitute a tandem-type and a triple-type solar cell in which a plurality of the laminated-structures are further laminated. The photoelectric conversion layer 3 is provided on the transparent conductive layer 2. The photoelectric conversion layer 3 is so divided by trenches 11 extending in the Y-direction near vicinities the trenches 10 as to correspond to the plurality of solar cells 5. With regard to the depth direction, the trenches 11 are formed from a surface of the photoelectric conversion layer 3 toward a surface of the transparent conductive layer 2.

The back electrode layer 4 is provided on the photoelectric conversion layer 3. The back electrode layer 4 is so divided by trenched 12 extending in the Y-direction near the trenches 11 as to correspond to the plurality of solar cells 5. With regard to the depth direction, the trenches 12 are formed from a surface of the back electrode layer 4 toward a surface of the photoelectric conversion layer 3.

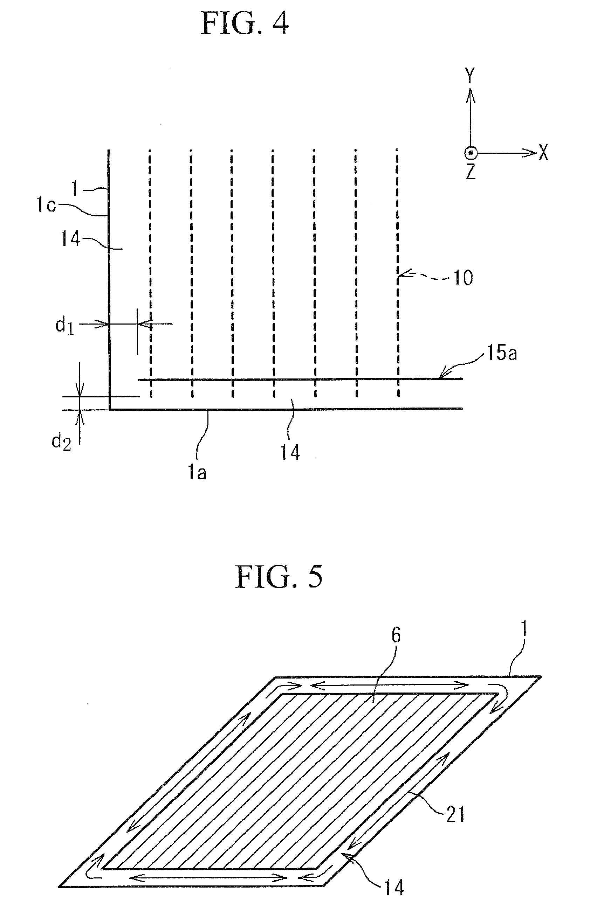

FIG. 4 is a schematic view magnifying the section-A shown in FIG. 2. The edge of the X-direction insulating trench 15a on the third side 1c side is away from the edge of the substrate 1 at a distance d1. Similarly, the edge of the X-direction insulating trench 15a on the fourth side 1d side is away from the edge of the substrate 1 at the distance d1, which is not shown. The same applies to both edges of the X-direction insulating trench 15b, which is not shown. Since the X-direction insulating trenches 15 (15a, 15b) are away from the both edges of the substrate 1 at the distance d1, they do not reach the edges of the substrate. As a result, it is prevented that the external moisture intrudes from the edge of the solar panel into the solar cell module 6 due to the capillary phenomenon in the trenches. In other words, it is possible to prevent the occurrence of the deterioration of the photovoltaic cells 5 caused by the moisture intrusion through the X-direction insulating trenches 15. It is thereby possible to suitably perform the insulating trench processing processes around the edges of the solar cell module such that the long-term reliability is further improved.

It is preferable that the distance d1 is equal to or less than 10 mm from the viewpoint of securing an area of the solar cell module 6 as large as possible. Moreover, a variety of comparative experiments are performed to suppress the intrusion of the external moisture from the edge of the solar panel, and it is found that a good adhesion region for the back sheet via EVA and the like in the peripheral region 14 is desirably larger than 5 mm. It is therefore preferable that the distance d1 is equal to or larger than 5 mm.

An edge of the trench 10 on the first side 1a side is away from the edge of the substrate 1 at a distance d2. Similarly, an edge of the trench 10 on the second side 1b side is away from the edge of the substrate 1 at the distance d2, which is not shown. Since the trenches 10 are away from the both edges of the substrate 1 at the distance d2, the trenches 10 do not reach the edges of the substrate 1. As a result, it is prevented that the external moisture intrudes into the solar cells 5 through those trenches. In other words, it is possible to prevent the occurrence of the deterioration of the photovoltaic cells 5 caused by the moisture intrusion through the trenches 10. It is thereby possible to suitably perform the trench processing processes with respect to solar cell module such that the long-term reliability is further improved.

It is preferable that the distance d2 is equal to or less than 10 mm from the viewpoint of securing an area of the solar cell module 6 as large as possible. Moreover, it is desirable that a good adhesion region for the back sheet via EVA and the like in the peripheral region 14 is larger than 5 mm, as in the distance d1 with respect to the insulating trenches 15a and 15b. It is therefore preferable that the distance d1 is equal to or larger than 5 mm.

According to the present invention, neither a Y-direction insulating trench located adjacent to the third side 1c and parallel to the third side 1c nor a Y-direction insulating trench located adjacent to the fourth side 1d and parallel to the fourth side 1d, which are formed from the back electrode layer 4 being the surface of the plurality of photovoltaic cells 5 toward the surface of the substrate 1, is provided.

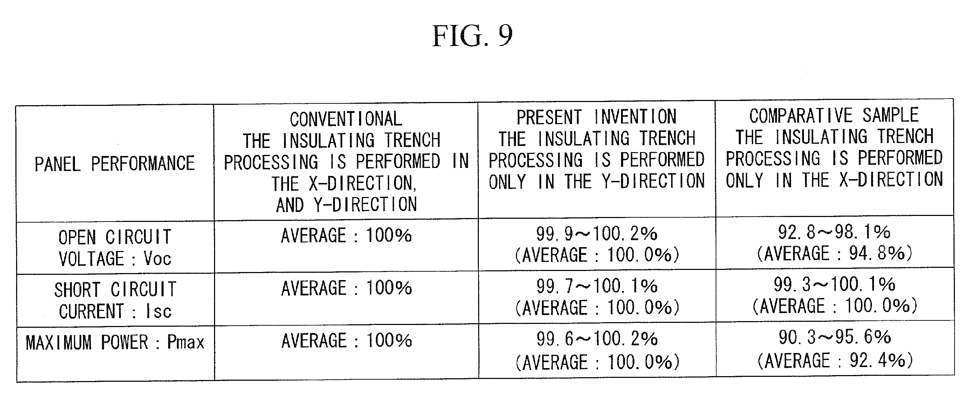

FIG. 9 is a table showing a comparison of performances between processing methods of insulating trenches of the solar panel according to the present invention, which was obtained through experiments conducted by the inventors. Ten solar panels 10 were manufactured under each condition, with regard to the insulating trenches, are prepared. Power generation characteristics of those solar panels were measured by using a solar simulator of AM 1.5 and global solar irradiance (1000 W/m2). An average of the measured values with respect to the conventional solar panel (FIG. 1), in which the insulating trenches are provided in the X- and the Y-directions on entire circumference of the solar panel, is 100 %. Comparative evaluations in that case are shown in FIG. 9. In a case of the solar panel (FIG. 2) according to the present invention in which the insulating trench processing is performed only in the X-direction, the characteristics including the open circuit voltage Voc, the short circuit current Isc and the maximum power Pmax have no difference in initial performance as compared with the conventional solar panel (FIG. 1).

On the other hand, in a case of a solar panel as a comparative example in which the insulating trench processing is performed only in the Y-direction, performance deterioration is found particularly in the open circuit voltage Voc, as compared with the conventional solar panel. When a polishing is performed with respect to a film of the photovoltaic cells 5 in the solar cell peripheral region after the insulating trench processing, the same insulation effect as by the insulating trench processing can be obtained with regard to the Y-direction. It is therefore possible to omit the insulating trench processing in the Y-direction. However, with regard to the X-direction, the back electrode layer 4 and the transparent conductive layer 2 are likely to short-circuit with each other in a region where the plurality of photovoltaic cells 5 are serially connected one after another, at the time of the polishing of the film of the photovoltaic cells 5 in the peripheral region. Therefore, if the insulating trench processing in the X-direction is omitted, problems will arise.

Moreover, with respect to the solar panel (FIG. 2) according to the present invention, confirmatory experiments were performed where an outdoor severe conditions were simulated. Light exposure was performed in advance for 20 hours under a condition of AM 1.5 and global solar irradiance (1000 W/m2), to stabilize the performance. After that, high-temperature/high-humidity test (temperature of 85 degrees centigrade, humidity of 85 %, evaluating time of 1000 hours) defined in the JISC8938 is performed. As a result, it was confirmed that there was no change in the performance.

As described above, even if the Y-direction insulating trenches are not provided, it is possible to achieve the initial performance similar to that having the Y-direction insulating trenches. It is therefore possible not only to suppress the deterioration in the performance of the solar cell module but also to reduce the processing time of the insulating trench processing processes at the edge sections of the solar cell module.

FIG. 5 is a view regarding the peripheral region of the solar panel in the embodiment of the present invention. The peripheral region 14 is a region in which a film formed on the substrate for the solar cell is removed by the polishing. In removing the film in the peripheral region 14, any one of a grinding by using a rotating grindstone and a blast grinding (using alumina particle whose particle size is about 10 to 50 micrometers) is normally adopted. However, in the case of the rotating grindstone grinding, it is difficult to control a thickness of a film to be removed. Over-grinding of the substrate 1 results in decrease in the strength of the substrate 1. On the other hand, if the transparent conductive layer 2 remains, a problem of the adhesion site bonded to the back sheet via EVA or the like and a problem that insulation property is deteriorated by the remaining transparent conductive layer 2 are likely to occur. As for the blast grinding, a masking for separating a removal region from a non-removal region becomes complicated and difficult. If the film to be removed is thick, the exhaustion and deformation of the masking is likely to occur early.

According to the present invention, a rough grinding is performed in an early stage through the polishing by using the rotating grindstone, with respect to all of the back electrode layer and the photoelectric conversion layer and a part of the transparent conductive layer 2 which constitute more than 50 % of the thickness of the whole laminated films of the photovoltaic cell 5. Moreover, the residual film is grinded by the blast grinding. As a result, it is possible to improve accuracy and reliability of the grinding. It is thus possible to prevent the problems caused by the over-grinding of the substrate 1 or the residue of the transparent conductive layer 2. Therefore, the adhesion between the back sheet and the substrate 1 via EVA and the like becomes uniform, and its adhesive strength becomes an excellent state. As a result, it is possible to prevent the intrusion of the external moisture into the photovoltaic cell 5 therefrom, and to maintain the long-term reliability.

In FIG. 5, after the film in the peripheral region 14 is removed by only the rotating grindstone grinding or by a combination of the rotating grindstone grinding and the blast grinding, a hairline processing is further performed in the peripheral region 14. A grinding direction 21 indicates rough position and direction in which the hairline processing is performed. The hairline processing is a process of finishing the adhesive surface (peripheral region 14) for the purpose of not only increasing adhesiveness between the back sheet and the substrate 1 via EVA and the like covering the solar cell module 6 but also cutting off the intrusion of the external moisture by eliminating a scar and a groove that are generate by the grinding and extend from around the edge of the solar panel to the side of the solar cell module 6 across the peripheral region 14.

If the scar or the groove extending toward the side of the solar cell module 6 across the peripheral region 14 remains for some reasons in the processes by the end of the removal of the film in the peripheral region 14, the external moisture may possibly intrude into the solar cell module 6 due to the capillary phenomenon. Therefore, the peripheral region 14 after the removal of the film is lightly grinded by using the grindstone to form a hairline, as the finish processing. As a result, even if the scar or the groove has remained, it is grinded and removed. Further, a trench extending toward the side of the solar cell module 6 across the peripheral region 14 is cut off also in the remained scar or groove. It is therefore possible to greatly increase adhesiveness of the adhesive surface between the back sheet and the substrate 1 via EVA or the like and also reliability of the sealing.

If a deep hairline is generated due to over grinding, the adhesiveness of the adhesive surface via EVA or the like deteriorates, which may work negatively. Therefore, it is desirable to employ soft grinding agent as the finish grindstone used in the hairline processing. As such grinding agent, for example, #400 to #1200 of silicon carbide-based can be employed. It may be possible to automatically run the finish grindstone in the peripheral region 14 with stressing a light load to be a rotating grindstone. Alternatively, manual handling may be possible. It should be noted the finish grindstone should move along the grinding direction 21 so as not to head to the outside across the edge of the substrate 1. As described above, since the grinding is performed without running off the peripheral region 14, the scar or the groove does not reach the edge of the substrate 1 even if the scar or groove remains. As a result, the intrusion of the external moisture into the solar cell 5 through the trench is prevented. In other words, it is possible to prevent the occurrence of the deterioration of the photovoltaic cells 5 caused by the moisture from the scar or the groove. It is therefore possible to further improve the long-term reliability while improving the adhesiveness with the back sheet via EVA and the like.

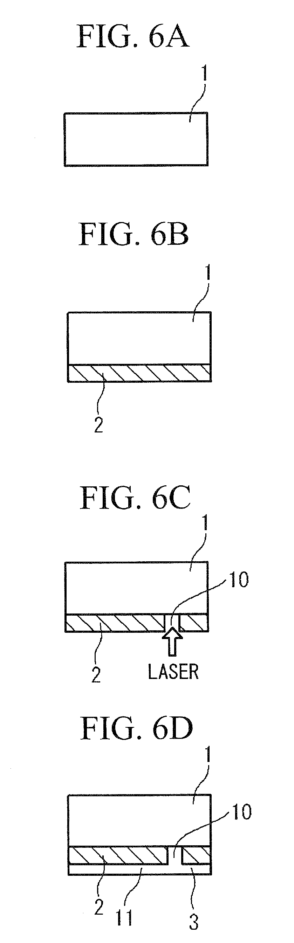

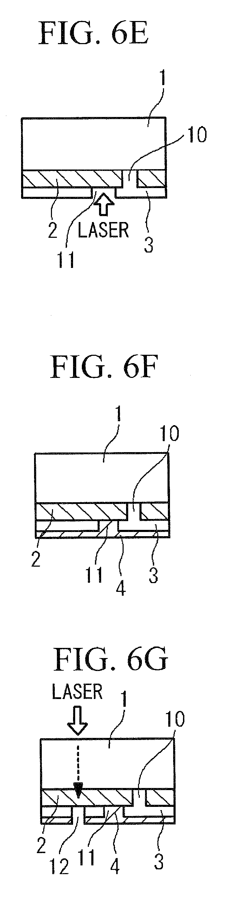

Next, a method of manufacturing the solar panel according to the embodiment of the present invention will be described. Described here is an example where a single-layer amorphous silicon thin-film solar cell is provided as the photovoltaic cell 5 on a glass substrate as the substrate 1. FIGS. 6A to 6H, FIG. 7A, FIG. 7B, and FIGS. 8A to 8D are views illustrating a method of manufacturing the solar panel according to the embodiment of the present invention.

### (1) FIG. 6A:

A soda float glass substrate (1.4 m × 1.1 m × substrate thickness: 4 mm) is used as the substrate 1. It is desirable for preventing damage that corner chamfering or round chamfering is performed with respect to an edge face of the substrate.

### (2) FIG. 6B:

A transparent electrode film consisting primarily of a tin oxide film (SnO2) is used as the transparent conductive layer 2. For example, a transparent electrode film with a thickness of about 500 to 800 nm is formed under a condition of about 500 degrees centigrade by using a thermal CVD (CVD: Chemical Vapor Deposition) apparatus. At this time, a texture having appropriate concavity and convexity is formed on a surface of the transparent electrode film. In addition to the transparent electrode film, an alkali barrier film (not shown) may be formed between the substrate 1 and the transparent electrode film, as the transparent conductive layer 2. Used as the alkali barrier film is, for example, a silicon oxide film (SiO2) with a thickness of 50 to 150 nm that is formed under a condition of about 500 degrees centigrade by using a thermal CVD apparatus.

### (3) FIG. 6C:

After that, the substrate 1 is placed on an X-Y table. Then, the first harmonic (1064 nm) of a laser diode-excited YAG laser is incident from a film surface side of the transparent electrode film, as indicated by an arrow in the figure. The pulse oscillation frequency is set to 5 to 20 kHz, and the laser power is adjusted appropriately in accordance with processing speed. The transparent electrode film is laser-etched such that the trenches 10 are formed in a direction perpendicular to a direction in which the photovoltaic cells 5 are connected in series, to be a strip-shape with a width of about 6 to 10 mm. The laser etching is stopped at a position 5 to 10 mm away from the edge of the substrate 1. The stopping of the etching may be stopping of the laser beam. Alternatively, a metal masking board can be simply placed on the non-laser etching region of the substrate 1. To stop the etching at the position 5 to 10 mm away from the edge of the substrate 1 is effective in suppressing the intrusion of the external moisture from the edge of the solar panel into the solar cell module 6.

### (4) FIG. 6D:

By using a plasma CVD apparatus, the photoelectric conversion layer 3 is formed under a condition of reduced-pressure atmosphere (30 to 150 Pa) and about 200 degrees centigrade. As the photoelectric conversion layer 3, a p-layer film / an i-layer film/ a n-layer film made of amorphous silicon thin-film are formed in order. The photoelectric conversion layer 3 is formed on the transparent conductive layer 2 by using SiH₄ gas and H₂ gas as main row material. The p-layer, the i-layer and the n-layer are laminated in this order from the solar light incident side. In the present embodiment, the p-layer consists primarily of B-doped amorphous SiC, and its film thickness is 10 to 30 nm. The i-layer consists primarily of amorphous Si, and its film thickness is 250 to 350 nm. The n-layer consists primarily of p-doped microcrystalline Si, and its film thickness is 30 to 50 nm. In order to improve interface property, a buffer layer may be provided between the p-layer film and the i-layer film.

### (5) FIG. 6E:

The substrate 1 placed on the X-Y table. Then, the second harmonic (532 nm) of the laser diode-excited YAG laser is incident from a film surface side of the photoelectric conversion layer 3, as indicated by an arrow in the figure. The pulse oscillation frequency is set to 10 to 20 kHz, and the laser power is adjusted appropriately in accordance with processing speed. A laser etching is performed such that the trenches 11 are formed about 100 to 150 micrometers laterally away from the laser etching line on the transparent conductive layer 2.

### (6) FIG. 6F:

As the back electrode layer 4, an Ag film / a Ti film are formed in this order under a condition of reduced-pressure atmosphere and about 150 degrees centigrade by using a sputtering apparatus. As the back electrode layer 4, the Ag film (200 to 500 nm) and the Ti film (10 to 20 nm) having high anticorrosion property for protecting it are laminated in this order. For the purpose of reducing contact resistance between the n-layer and the back electrode layer 4 and improving light reflection, a GZO (Ga-doped ZnO film) may be provided between the photoelectric conversion layer 3 and the back electrode layer 4. For example, a GZO with a thickness of 50 to 100 nm is formed by using a sputtering apparatus.

### (7) FIG. 6G:

The substrate 1 placed on the X-Y table. Then, the second harmonic (532 nm) of the laser diode-excited YAG laser is incident from a side of the substrate 1, as indicated by an arrow in the figure. The laser beam is absorbed by the photoelectric conversion layer 3. Due to high gas vapor pressure generated at this time, the back electrode layer 4 explodes and is removed. The pulse oscillation frequency is set to 1 to 10 kHz, and the laser power is adjusted appropriately in accordance with processing speed. A laser etching is performed such that the trenches 12 are formed about 250 to 400 micrometers laterally away from the laser etching line on the transparent conductive layer 2.

### (8) FIG. 6H:

Power generation region is divided to remove an influence that the serial connection part in the film edge section around the edge of the substrate is likely to short-circuit due to the laser etching. More specifically, the substrate 1 placed on the X-Y table. Then, the second harmonic (532 nm) of the laser diode-excited YAG laser is incident from the side of the substrate 1. The laser beam is absorbed by the transparent conductive layer 2 and the photoelectric conversion layer 3. Due to high gas vapor pressure generated at this time, the back electrode layer 4 explodes and is removed. The pulse oscillation frequency is set to 1 to 10 kHz, and the laser power is adjusted appropriately in accordance with processing speed. A laser etching is performed such that the X-direction insulating trenches 15 are formed at positions 5 to 15 mm away from the edge of the substrate 1. Here, the Y-direction insulating trenches are not formed. The laser etching is stopped at a position 5 to 10 mm away from the edge of the substrate 1. The stopping of the etching may be stopping of the laser beam. Alternatively, a metal masking board can be simply placed on the non-laser etching region of the substrate 1. To stop the etching at the position 5 to 10 mm away from the edge of the substrate 1 is effective in suppressing the intrusion of the external moisture from the edge of the solar panel into the solar cell module 6.

### (9) FIG. 7A:

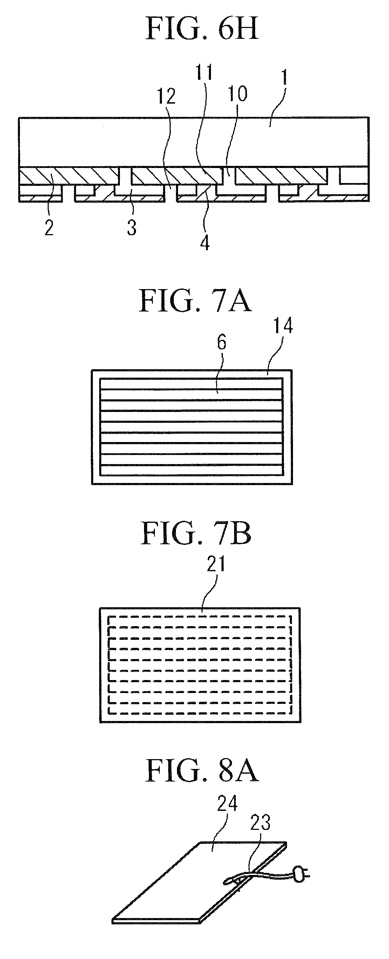

The laminated film in the circumference (peripheral region 14) of the substrate 1 has steps and is likely to exfoliate. The film is removed in order to secure a good adhesive surface with respect to the back sheet via EVA and the like in the post process. First, an initial rough grinding is performed with respect to the back electrode layer 4 / photoelectric conversion layer 3 / transparent conductive layer 2 located on the substrate-edge side of the insulating trenches 15 that are provided in a region 5 to 15 mm away from the edge of the substrate in the foregoing process shown in FIG. 6H. The initial rough grinding is achieved by a grinding using a rotating grindstone. In an early stage, all of the back electrode layer 4 and the photoelectric conversion layer 3 and a part of the transparent conductive layer 2, which constitute more than 50 % of the thickness of the whole laminated films of the photovoltaic cell 5, are removed by the rotating grindstone grinding. After the rough grinding is completed, the residual is removed by the blast grinding. Next, the finish grinding (hairline processing) is performed by using a rotating grindstone having a width of 3 to 5 mm and made of #800 silicon carbide-based grinding agent. Through this process, trenches extending toward the side of the solar cell module 6 across the peripheral region 14 are cut off in the remaining scar and groove. The grinding debris and abrasive grain are removed by washing the substrate 1.

### (10) FIG. 7B:

The back sheet is provided with an open penetration window in a terminal box mounting portion through which a current collector is taken out. A plurality layers of insulating material are provided at the open penetration windowportion. As a result, the intrusion of the external moisture and the like is suppressed. By using copper foil, the power is collected from the photovoltaic cell 5 on one end of serial connection and the photovoltaic cell 5 on the other end. In this manner, the processing is performed so that the electric power is collected from the terminal box portion on the back side of the solar panel. In order to prevent the short-circuit between the copper foil and other members, an insulating sheet wider than the width of the copper foil is provided. After the copper foil and the like for use in the power collection are placed at predetermined positions, whole of the solar cell module 6 is covered. A filler sheet of EVA (ethylene-vinyl acetate copolymer) or the like is so arranged as not to protrude from the substrate 1. A back sheet with high waterproof property is provided on the EVA. For example, the back sheet has a three-layer structure of PTE sheet / AL foil / PET sheet, which has high waterproof/moistureproof property. After that, an internal deaeration is performed under reduced-pressure atmosphere by using a laminator. Then, a pressing is performed under a condition of about 150 to 160 degrees centigrade, and adherence is achieved by the EVA cross-linking.

### (11) FIG. 8A:

The terminal box is attached to the back side of the solar cell module 6 by using adhesive agent.

### (12) FIG. 8B:

The copper foil and an output cable of the terminal box are connected with each other by using solder and the like. Further, the interior of the terminal box is filled with sealant (potting agent) and sealed. Thus, the solar panel is completed.

### (13) FIG. 8C:

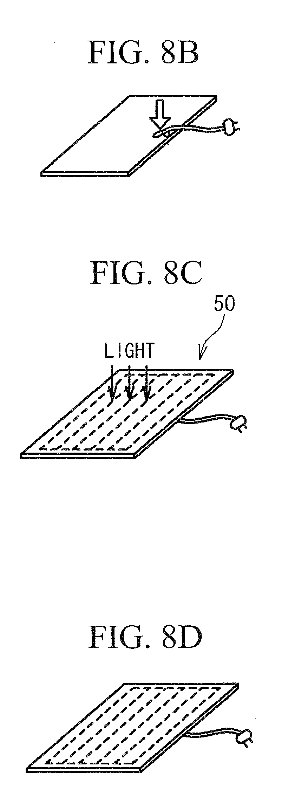

A comparison is made with the conventional solar panel (FIG. 1) that has the insulating trenches in the X- and Y-directions on the entire circumference of the solar panel. For that purpose, a power generation test and a predetermined performance test are conducted with regard to the solar panel formed through the processes to FIG. 8B. The power generation test is conducted under a condition of AM 1.5 and the global solar irradiance (1000 W/m2) by using a solar simulator.

### (14) FIG. 8D:

The predetermined performance test is conducted before or after the power generation test (FIG. 8C).

### (i) Insulation test:

A load of DC: 1000 V is applied between an output terminal of the laminated solar panel and a conductive potion such as the edge surface of the substrate, the back sheet and so on. Then, it is confirmed that the resistance is equal to or more than 100 MΩ.

### (ii) Withstand voltage test

A load of DC: 3800 V (or 2200 V) is applied for one minute between the output terminal of the laminated solar panel and the conductive potion such as the edge surface of the substrate, the back sheet and so on. Then, it is confirmed that dielectric breakdown does not occur.

### (iii) High-temperature/high-humidity test

Finally, it is confirmed that the structure and the manufacturing conditions are appropriate, although the method of manufacturing is changed. More specifically, the performance is stabilized in advance by performing a light exposure processing for 20 hours under a simulated outdoor severe condition in accordance with the JISC8938. After that, it is confirmed that the performance remains the same for a predetermined evaluating time (1000 hours) under the high-temperature and high-humidity condition (temperature of 85 degrees centigrade, humidity of 85 %). It is confirmed that the appearance is not changed, initial performance of 95 % is ensured, and the performance remains the same.

By the above-described manufacturing method, the solar panel product using the present invention can be manufactured. It is confirmed that its characteristics remain the same as that manufactured by the conventional process. Moreover, it is confirmed by the high-temperature/high-humidity test (long-term reliability confirmation test) that the appearance does not change even when the evaluating time is further extended and that the reliability is improved as compared with the conventional process.

According to the present invention, both edges of the trench 10 are located short of the both sides (the first side 1a and the second side 1b) of the substrate 1. As a result, it is prevented that the external moisture intrudes into the photovoltaic cell 5 through the trench 10. It is therefore possible to prevent the occurrence of the deterioration of the photovoltaic cell 5 caused by the intrusion of the moisture through the scar or the groove. Inotherwords, it is possible to suitablyperform the trench processing processes with respect to the solar cell module such that the long-term reliability is further improved.

According to the present invention, the X-direction insulating trenches 15 are provided, while the Y-direction insulating trenches are not provided. It is therefore possible to reduce the trench processing processes and hence to reduce the processing time. Even in that case, the characteristics of the solar cell module do not change at all, which was confirmed by the experiments conducted by the inventors of the present invention. That is to say, it is possible to reduce the processing time required for the trench processing around the edge section of the solar cell module, without deteriorating the performance of the solar cell module. As a result, the productivity is improved.

According to the present invention, both edges of the trench 10 are so located as not to reach the both sides (the first side 1a and the second side 1b) of the substrate 1. As a result, it is prevented that the external moisture intrudes into the photovoltaic cell 5 through the trench 10. It is therefore possible to prevent the occurrence of the deterioration of the photovoltaic cell 5 caused by the intrusion of the moisture through the trench. In other words, it is possible to suitably perform the trench processing processes with respect to the solar cell module such that the long-term reliability is further improved.

According to the present invention, both edges of the X-direction insulating trench 15 are so located as not to reach the both sides (the third side 1c and the fourth side 1d) of the substrate 1. As a result, it is prevented that the external moisture intrudes into the photovoltaic cell 5 through the X-direction insulating trench 15. It is therefore possible to prevent the occurrence of the deterioration of the photovoltaic cell 5 caused by the intrusion of the moisture through the trench. In other words, it is possible to suitably perform the trench processing processes with respect to the solar cell module such that the long-term reliability is further improved.

According to the present invention, the polishing of the peripheral region 14 is performed over the above-mentioned three stages by different methods. As a result, it is possible to reliably remove the film in the peripheral region 14 without leaving the scar or the groove in the peripheral region 14. It is thus possible to suitably perform the polishing of the peripheral region of the solar cell module without deteriorating the long-term reliability.

In the above-described embodiment, the amorphous silicon thin-film is used as the photoelectric conversion layer 3. The present invention can be similarly applied to other types of thin-film solar cell such as a microcrystalline silicon-based solar cell and a tandem-type solar cell in which one-to-plural layers of amorphous silicon-based solar cell and microcrystalline silicon-based solar cell are laminated. Furthermore, the present invention can be similarly applied to a solar cell of a type in which a back electrode (the back means opposite to the incidence of light) is formed on a metal substrate or the like, and a photoelectric conversion layer and a light-incident-side transparent conductive layer are formed thereon.

## Claims

1. A solar panel comprising:
a substrate with translucency having a first side, a second side facing said first side, a third side between said first side and said second side, and a fourth side facing said third side; and
a plurality of photovoltaic cells provided on said substrate, arranged parallel to said first side, and connected in series one after another,
wherein each of said plurality photovoltaic cells includes a transparent conductive layer, a photoelectric conversion layer and a back electrode layer which are formed on said substrate in this order,
wherein said plurality of photovoltaic cells have a first trench located adjacent to said first side and parallel to said first side and a second trench located adjacent to said second side and parallel to said second side, while do not have a trench located adjacent to said third side and parallel to said third side and a trench located adjacent to said fourth side and parallel to said fourth side,
wherein said first trench and said second trench are formed from said back electrode layer being a surface of said plurality of photovoltaic cells toward a surface of said substrate, and so extend to vicinities of said third side and said fourth side as not to reach an edge of said substrate.

2. The solar panel according to claim 1,
wherein edges of said first trench and said second trench are away from an edge of said substrate at a distance not less than 5 mm and not more than 10 mm.

3. The solar panel according to claim 1 or 2,
wherein said plurality of photovoltaic cells has a first film formed on said substrate, and said first film has a third trench extending in a direction different from directions of said first side and said second side,
wherein said third trench is formed from a surface of said first film toward a surface of said substrate, and so extends to vicinities of said first side and said second side as not to reach an edge of said substrate.

4. The solar panel according to claim 3,
wherein an edge of said third trench is away from an edge of said substrate at a distance not less than 5 mm and not more than 10 mm.

5. A method of manufacturing a solar panel comprising:
(a) a process of forming a plurality of photovoltaic cells on a substrate having a first side, a second side facing said first side, a third side between said first side and said second side, and a fourth side facing said third side,
wherein said plurality of photovoltaic cells are arranged parallel to said first side and connected in series one after another, and each of said plurality photovoltaic cells includes a transparent conductive layer, a photoelectric conversion layer and a back electrode layer which are formed on said substrate in this order; and
(b) a process of forming a first trench located adjacent to said first side and parallel to said first side and a second trench located adjacent to said second side and parallel to said second side,
wherein a trench located adjacent to said third side and parallel to said third side and a trench located adjacent to said fourth side and parallel to said fourth side are not formed,
wherein said first trench and said second trench are formed from said back electrode layer being a surface of said plurality of photovoltaic cells toward a surface of said substrate, and so extend to vicinities of said third side and said fourth side as not to reach an edge of said substrate.

6. The method of manufacturing a solar panel according to claim 5,
wherein said (b) process includes: (b1) a process of forming said first trench and said second trench such that edges of said first trench and said second trench are away from an edge of said substrate at a distance not less than 5 mm and not more than 10 mm.

7. The method of manufacturing a solar panel according to claim 5 or 6,
wherein said (a) process includes:
(a1) a process of forming a transparent conductive layer on said substrate; and
(a2) a process of forming in said transparent conductive layer a third trench extending in a direction different from directions of said first side and said second side,
wherein said third trench is formed from a surface of said transparent conductive layer toward a surface of said substrate, and so extends to vicinities of said first side and said second side as not to reach an edge of said substrate.

8. The method of manufacturing a solar panel according to claim 7,
wherein said (a2) process includes: (a21) a process of forming said third trench such that an edge of said third trench is away from an edge of said substrate at a distance not less than 5 mm and not more than 10 mm.

9. The method of manufacturing a solar panel according to any one of claims 5 to 8, further comprising: (c) a process of removing a part of a film for said plurality of photovoltaic cells to laminate an exposed surface as an adhesive surface of a sheet material, when sealing said plurality of photovoltaic cells on said substrate by using said sheet material,
wherein said (c) process includes:
(c1) a process of polishing said film for said plurality of photovoltaic cells in a peripheral section of said substrate through a grinding with a rotating grindstone; and
(c2) a process of polishing said film for said plurality of photovoltaic cells in said peripheral section of said substrate through a blast grinding, after said (c1) process.

10. The method of manufacturing a solar panel according to claim 9, further comprising: (d) a process of polishing said peripheral section of said substrate with a grindstone such that a grinding groove generated by said grindstone does not cross said first side, said second side, said third side and said fourth side, in respective cases where said (c2) process is performed and where said (c2) process is not performed, after said (c1) process.
